# EUROPÄISCHE PATENTSCHRIFT

(11) **EP 1 568 112 B1**
(45) Veröffentlichungstag und Bekanntmachung des Hinweises auf die Patenterteilung: **12.07.2006**
(21) Anmeldenummer: 03776886.8
(22) Anmeldetag: 06.11.2003
(51) Int. Cl.: H01S 5/183

(54) **VERFAHREN ZUR HERSTELLUNG EINES VERGRABENEN TUNNELKONTAKTS IN EINEM OBERFLÄCHENEMITTIERENDEN HALBLEITERLASER**
METHOD FOR PRODUCING A BURIED TUNNEL JUNCTION IN A SURFACE-EMITTING SEMICONDUCTOR LASER
PROCEDE POUR REALISER UN CONTACT A EFFET TUNNEL ENFOUI DANS UN LASER SEMI-CONDUCTEUR EMETTANT PAR LA SURFACE

(30) Priorität: 27.11.2002 DE 10255307; 07.02.2003 DE 10305079
(43) Veröffentlichungstag der Anmeldung: 31.08.2005
(73) Patentinhaber: Vertilas GMBH, 85748 Garching (DE)
(72) Erfinder: AMANN, Markus-Christian, 80935 München (DE)
(74) Vertreter: Grunert, Marcus
(86) Internationale Anmeldenummer: PCT/EP2003/012433
(87) Internationale Veröffentlichungsnummer: WO 2004/049461

(56) Entgegenhaltungen:
- WO-A-98/07218
- DE-A- 10 107 349
- US-A- 5 661 075
- US-A- 6 052 398
- NAKAGAWA S ET AL: "88°C, CONTINUOUS-WAVE OPERATION OF APERTURED, INTRACAVITY CONTACTED, 1.55 MUM VERTICAL-CAVITY SURFACE-EMITTING LASERS" APPLIED PHYSICS LETTERS, AMERICAN INSTITUTE OF PHYSICS. NEW YORK, US, Bd. 78, Nr. 10, 5. März 2001 (2001-03-05), Seiten 1337-1339, XP001012107 ISSN: 0003-6951
- LIAU Z L ET AL: "A NOVEL TECHNIQUE FOR GAINASP/INP BURIED HETEROSTRUCTURE LASER FABRICATION" APPLIED PHYSICS LETTERS, AMERICAN INSTITUTE OF PHYSICS. NEW YORK, US, Bd. 40, Nr. 7, 1. April 1982 (1982-04-01), Seiten 568-570, XP000706414 ISSN: 0003-6951 in der Anmeldung erwähnt

## Beschreibung

Die Erfindung betrifft ein Verfahren zur Herstellung eines vergrabenen Tunnelkontakts in einem oberflächenemittierenden Halbleiterlaser sowie einen solchen Halbleiterlaser.

Oberflächenemittierende Laserdioden (engl.: Vertical-Cavity Surface-Emitting Laser: VCSEL) stellen Halbleiterlaser dar, bei denen die Lichtemission senkrecht zur Oberfläche des Halbleiterchips stattfindet. Verglichen mit konventionellen kantenemittierenden Laserdioden weisen die oberlächenemittierenden Laserdioden mehrere Vorteile auf, wie einen geringen elektrischen Leistungsverbrauch, die Möglichkeit der unmittelbaren Überprüfung der Laserdiode auf dem Wafer, einfache Ankoppelungsmöglichkeiten an eine Glasfaser, longitudinale Einmodenspektren und die Möglichkeit der Zusammenschaltung der oberflächenemittierenden Laserdioden zu einer zweidimensionalen Matrix.

Auf dem Gebiet der Kommunikationstechnik mittels Glasfasern besteht aufgrund der wellenlängenabhängigen Dispersion bzw. Absorption das Bedürfnis nach VCSELs in einem Wellenlängenbereich von ca. 1,3 bis 2 µm, insbesondere um die Wellenlängen von 1,31 µm oder 1,55 µm. Langwellige Laserdioden mit anwendungstauglichen Eigenschaften, speziell für den Wellenlängenbereich oberhalb 1,3 µm, werden bislang aus InP-basierten Verbindungshalbleitern hergestellt. GaAsbasierte VCSELs sind für den kurzwelligeren Bereich < 1,3 µm geeignet. Die folgenden Lösungsansätze wurden bisher verfolgt:

Ein Continuous-Wave VCSEL, der mit einer Leistung von 1 mW bei 1,55 µm emittiert, ist beispielsweise aus einem InP-Substrat mit metamorphen Schichten bzw. Spiegeln aufgebaut (IEEE Photonics Technology Letters, Volume 11, Number 6, June 1999, Seiten 629 bis 631). Ein weiterer Vorschlag bezieht sich auf einen kontinuierlich bei 1,526 µm emittierenden VCSEL, der durch Waferverbindung einer InP/InGaAsPaktiven Zone mit GaAs/AlGaAs-Spiegeln hergestellt ist (Applied Physics Letters, Volume 78, Number 18, Seiten 2632 bis 2633 vom 30. April 2001). Ein VCSEL mit Luft-Halbleiterspiegel (InP-Luftspalt-DBRs, für Distributed Bragg Reflectors) ist in IEEE ISLC 2002, Seiten 145 bis 146 vorgeschlagen. Hier ist zwischen der aktiven Zone und dem oberen DBR-Spiegel ein Tunnelkontakt angebracht, wobei durch Unterätzen der Tunnelkontaktschicht eine Strombegrenzung erreicht wird. Der den verbleibenden Tunnelkontaktbereich umgebende Luftspalt dient zur Wellenführung des optischen Feldes.

Weiterhin ist aus der Veröffentlichung zur 26. European Conference on Optical Communication, ECOC 2000, "88°C, Continous-Wave Operation of 1,55 µm Vertical-Cavity Surface-Emitting Lasers", ein VCSEL mit Antimonid-basierten Spiegeln bekannt, bei dem eine unterätzte InGaAs-aktive Zone von zwei n-dotierten InP-Schichten eingeschlossen ist, an die sich AlGaAsSb-DBR-Spiegel anschließen.

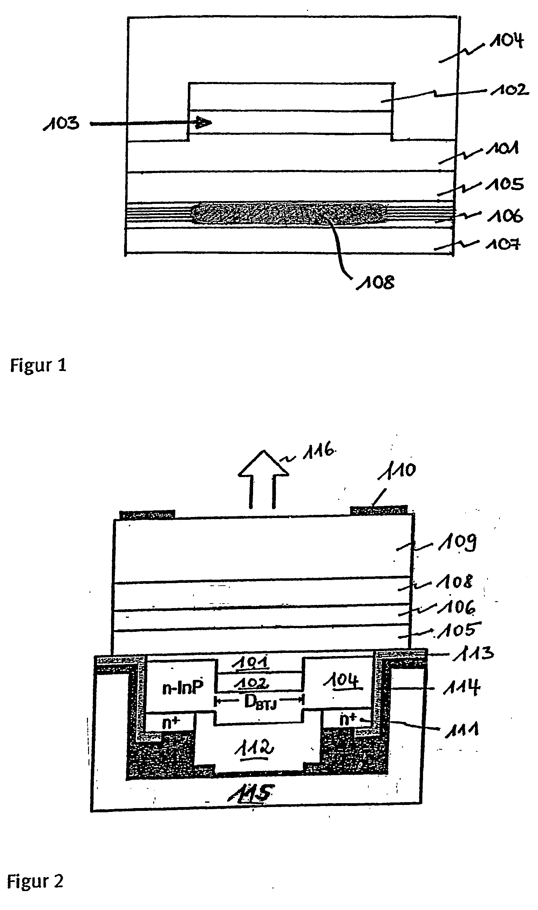

Die besten Eigenschaften hinsichtlich Leistung, Betriebstemperaturbereich und Modulationsbandbreite weisen jedoch VCSEL mit vergrabenen Tunnelkontakten (engl.: Buried Tunnel Junction, BTJ) auf. Herstellung und Struktur des vergrabenen Tunnelkontakts sollen im Folgenden anhand Figur 1 dargelegt werden. Mittels Molekularstrahlepitaxie (engl.: Molecular Beam Epitaxy, MBE) wird ein hochdotiertes p⁺/n⁺⁻Schichtenpaar 101, 102 mit geringem Bandabstand hergestellt. Zwischen diesen Schichten bildet sich der eigentliche Tunnelkontakt 103 aus. Durch reaktives Ionenätzen (engl.: Reactive Ion Etching, RIE) wird ein kreisförmiger oder elliptischer Bereich geformt, der im wesentlichen durch die n⁺-dotierte Schicht 102, den Tunnelkontakt 103 sowie eines Teils oder der gesamten p⁺-dotierten Schicht 101 gebildet wird. Dieser Bereich wird in einem zweiten E-pitaxiedurchlauf mit n-dotiertem InP (Schicht 104) überwachsen, sodass der Tunnelkontakt 103 "vergraben" ist. Der Kontaktbereich zwischen der überwachsenen Schicht 104 und der p⁺-dotierten Schicht 101 wirkt beim Anlegen einer Spannung als Sperrschicht. Der Strom fließt durch den Tunnelkontakt mit Widerständen von typisch 3 x 10⁻⁶ Ω cm². Hierdurch kann der Stromfluss auf den eigentlichen Bereich der aktiven Zone 108 beschränkt werden. Weiterhin ist die Wärmeerzeugung gering, da der Strom von einer hochohmigen p-dotierten zu einer niederohmigen n-dotierten Schicht fließt.

Die Überwachsung des Tunnelkontakts führt zu leichten Dikkenvariationen, die sich ungünstig auf die laterale Wellenführung auswirken, sodass das Entstehen höherer lateraler Moden insbesondere bei größeren Aperturen erleichtert ist. Für den - insbesondere bei der glasfaseroptischen Kommunikationstechnik geforderten - Einmodenbetrieb können daher nur kleine Aperturen mit entsprechend geringer Laserleistung verwendet werden. Ein weiterer Nachteil dieses Konzeptes ist die benötigte Zweifachepitaxie, die zur Überwachsung des vergrabenen Tunnelkontakts benötigt wird. In Analogie zu den GaAs-basierten kurzwelligen VCSELs wäre auch hier ein Herstellungsprozess mit nur einer Epitaxie aus Ausbeute- und Kostengründen von erheblichem Vorteil.

Beispiele und Anwendungen von VCSELs mit vergrabenen Tunnelkontakten finden sich beispielsweise in "Low-threshold index-guided 1,5 µm long wavelength vertical-cavity surface-emitting laser with high efficiency", Applied Physics Letter, Volume 76, Number 16, Seiten 2179 bis 2181 vom 17. April 2000, in "Long Wavelength Buried-Tunnel-Junction Vertical-Cavity Surface-Emitting Lasers", Adv. in Solid State Phys. 41, 75 bis 85, 2001, in "Vertical-cavity surface-emitting laser diodes at 1,55 µm with large output power and high operation temperature", Electronics Letters, Volume 37, Number 21, Seiten 1295 bis 1296 vom 11. Oktober 2001, in "90°C Continuous-Wave Ooperation of 1,83 µm Vertical-Cavity Surface-Emitting Lasers", IEEE Photonics Technology Letters, Volume 12, Number 11, Seiten 1435 bis 1437, November 2000, sowie in "High-Speed modulation up to 10 Gbit/s with 1,55 µm wavelength InGaAlAs VCSELs", Electronics Letters, Volume 38, Number 20, 26. September 2002.

Im Folgenden soll ausgehend von dem beschriebenen Aufbau des vergrabenen Tunnelkontakts in Figur 1 kurz die Struktur des in der oben genannten Literatur behandelten InP-basierten VCSEL anhand Figur 2 erläutert werden.

Der vergrabene Tunnelkontakt (BTJ) ist in dieser Struktur umgekehrt angeordnet, sodass die aktive Zone 106 oberhalb des Tunnelkontakts mit dem Durchmesser D_{BTJ} zwischen der p⁺⁻dotierten Schicht 101 und der n⁺-dotierten Schicht 102 gelegen ist. Die Laserstrahlung tritt in der mit dem Pfeil 116 dargestellten Richtung aus. Die aktive Zone 106 ist von einer p-dotierten Schicht 105 (InAlAs) und von einer n-dotierten Schicht 108 (InAlAs) umgeben. Der vorderseitige Spiegel 109 oberhalb der aktiven Zone 106 besteht aus einem epitaxialen DBR mit etwa 35 Schichtpaaren InGaAlAs/InAlAs, wodurch sich eine Reflektivität von etwa 99,4% ergibt. Der hinterseitige Spiegel 112 besteht aus einem Stapel dielektrischer Schichten als DBR und wird von einer Goldschicht abgeschlossen, wodurch sich eine Reflektivität von nahezu 99,75% ergibt. Eine Isolierschicht 113 vermeidet den direkten Kontakt der n-InP-Schicht 104 mit der meist aus Gold oder Silber bestehenden p-seitigen Kontaktschicht 114 (siehe hierzu DE 101 07 349 Al).

Die Kombination aus dielektrischem Spiegel 112 und der integrierten Kontaktschicht 114 und Wärmesenke 115 resultiert in einer stark erhöhten Wärmeleitfähigkeit verglichen mit epitaxialen Vielschichtstrukturen. Strom wird über die Kontaktschicht 114 bzw. über die integrierte Wärmesenke 115 und den n-seitigen Kontaktstellen 110 injiziert. Zu weiteren Einzelheiten bezüglich der Herstellung und den Eigenschaften der in Figur 2 dargestellten VCSEL-Typen sei ausdrücklich nochmals auf die oben zitierten Literaturstellen hingewiesen.

Ziel der Erfindung ist es nunmehr, eine insbesondere InPbasierte oberflächenemittierende Laserdiode mit vergrabenem Tunnelkontakt (BTJ-VCSEL) anzugeben, die sich preiswerter und mit höherer Ausbeute fertigen lässt.. Außerdem soll der laterale Einmodenbetrieb auch bei größeren Aperturen stabil sein, wodurch eine insgesamt höhere Einmodenleistung ermöglicht werden soll. Das erfindungsgemäße Verfahren zur Herstellung eines vergrabenen Tunnelkontakts in einem oberflächenemittierenden Halbleiterlaser, der eine einen pn-Übergang aufweisende aktive Zone umgeben von einer ersten n-dotierten Halbleiterschicht und mindestens einer p-dotierten Halbleiterschicht aufweist sowie einen Tunnelkontakt auf der p-Seite der aktiven Zone, der an eine zweite n-dotierte Halbleiterschicht grenzt, sieht, gemäß Anspruch 1 die folgenden Schritte vor: In einem ersten Schritt wird die für den Tunnelkontakt vorgesehene Schicht mittels materialselektiver Ätzung bis zum gewünschten Durchmesser des Tunnelkontakts lateral abgetragen, so dass ein geätzter Spalt verbleibt, der den Tunnelkontakt umgibt. In einem zweiten Schritt wird der Tunnelkontakt in einer geeigneten Atmosphäre so lange erhitzt, bis der geätzte Spalt durch Massetransport aus zumindest einer an den Tunnelkontakt grenzenden Halbleiterschicht geschlossen ist. Die an den Tunnelkontakt grenzenden Halbleiterschichten sind die zweite n-dotierte Halbleiterschicht auf der der aktiven Zone abgewandten Seite sowie eine p-dotierte Halbleiterschicht auf der der aktiven Zone zugewandten Seite des Tunnelkontaktes.

Für die genannte Massetransporttechnik ("Mass-Transport"-Technik, MTT) ist es besonders vorteilhaft, wenn zumindest eine der genannten an den Tunnelkontakt grenzenden Halbleiterschichten aus einer Phosphid-Verbindung, insbesondere InP, besteht.

Die vorliegende Erfindung löst sowohl das Problem der Zweifachepitaxie als auch das der eingebauten lateralen Wellenführung durch den Einsatz der genannten "Mass-Transport"-Technik. Die MTT ersetzt dabei den zweiten Epitaxieprozess und führt dabei nicht zu der sonst entstehenden lateralen Dickenvariation mit der Konsequenz einer starken lateralen Wellenführung. Das Vergraben des Tunnelkontakts findet nun nicht mehr durch Überwachsung statt, sondern durch Unterätzung der Tunnelkontaktschicht und anschließendes Verschließen des geätzten Bereichs mittels Massentransport aus benachbarten Schichten. Hierdurch können oberflächenemittierende Laserdioden preiswerter und mit höherer Ausbeute gefertigt werden. Zudem ist der laterale Einmodenbetrieb auch bei größeren Aperturen stabilisiert, wodurch sich eine höhere Einmodenleistung ergibt.

Die Massentransport-Technik wurde in einem anderen Zusammenhang Anfang der 80er Jahre zur Herstellung vergrabener aktiver Zonen für die so genannten Buried-Heterostructure (BH) Laserdioden auf InP-Basis eingesetzt (siehe "Study and Application of the Mass-Transport Phenomenon in InP", Journal of Applied Physics 54(5), Mai 1983, Seiten 2407 bis 2411 sowie "A Novel Technique for GaInAsP/InP Buried Heterostructure Laser Fabrication", in Applied Physics Letters 40(7), 1. April 1982, Seiten 568 bis 570). Das Verfahren erwies sich jedoch aufgrund erheblicher Degradationsprobleme als nachteilig. Diese Degradation der mittels MTT hergestellten Laser beruht auf der Erosion der seitlichen Ätzflanken der aktiven Zone, die durch MTT nicht in ausreichender Qualität geschützt werden können. Zu Einzelheiten und zur Durchführung der Massentransport-Technik sei ausdrücklich auf die genannten Literaturstellen verwiesen.

Es hat sich herausgestellt, dass der erwähnte Alterungsmechanismus bei der Massentransport-Technik, der die Realisierung brauchbarer BH-Laser verhindert hat, bei der Einbettung von Tunnelkontakten keine Rolle spielt, da in diesen kein hoch angeregtes Elektron-Loch-Plasma wie in einer aktiven Zone des Lasers vorliegt und somit Oberflächenrekombinationen, die die Degradationsprobleme verursachen, nicht auftreten.

Die Erfindung der "Mass-Transport"-VCSELs (MT-VCSEL) erlaubt technologisch einfacher herzustellende und bezüglich der maximalen Einmodenleistung bessere langwellige VCSELs, insbesondere auf InP-Basis.

Der Massentransport-Prozess wird vorzugsweise in einer Phosphor-Atmosphäre, beispielsweise bestehend aus H₂ mit PH₃, ausgeführt, während die Erhitzung des Bauteils erfolgt. Der bevorzugte Temperaturbereich liegt zwischen 500 und 800°C, vorzugsweise zwischen 500 und 700°C. Eine Möglichkeit der Massetransport-Technik besteht darin, den Wafer mit H₂ und PH₃ in strömender Atmosphäre zu behandeln, während er auf 670°C erhitzt und anschließend für eine weitere Zeitspanne auf dieser Temperatur gehalten wird (Gesamtbehandlungsdauer etwa eine Stunde). Auch Experimente mit InP-Schichten in einer Wasserstoff-Atmosphäre führten zu einem Massentransport von InP.

Durch den Massentransport-Prozess schließt sich der geätzte Spalt und vergräbt somit den Tunnelkontakt. Aufgrund des hohen Bandabstands von InP und der geringen Dotierung stellen die an den Tunnelkontakt grenzenden, durch Massetransport geschlossenen Bereiche keine Tunnelkontakte dar und sperren daher den Stromfluss. Andererseits tragen diese Bereiche aufgrund der hohen Wärmeleitfähigkeit von InP wesentlich zur Wärmeabfuhr bei.

Zur Herstellung einer oberflächenemittierenden Laserdiode gemäß der Erfindung, ist es vorteilhaft, von einer epitaktischen Ausgangsstruktur auszugehen, bei der auf der p-Seite der aktiven Zone nacheinander eine p-dotierte Halbleiterschicht, die für den Tunnelkontakt vorgesehene Schicht und daran anschließend die zweite n-dotierte Halbleiterschicht aufgebracht sind, wobei zunächst mittels Photolithographie und/oder Ätzung (beispielsweise reaktives Ionenätzen (engl.: Reactive Ion Etching, RIE)) ein kreisförmiger oder elliptischer Stempel geformt wird, dessen Flanken die zweite n-dotierte Halbleiterschicht und die für den Tunnelkontakt vorgesehene Schicht in Richtung senkrecht zur Schicht umfassen und zumindest bis unterhalb der Tunnelkontaktschicht reichen, und dass anschließend die erfindungsgemäße Unterätzung der Tunnelkontaktschicht sowie die Vergrabung des Tunnelkontakts mittels Massetransport erfolgt.

Die auf diese Weise erhaltene Struktur ist ideal zur Herstellung oberflächenemittierender Laserdioden geeignet.

In einer weiteren Ausgestaltung der Erfindung ist eine weitere Halbleiterschicht vorgesehen, die sich auf der p-Seite der aktiven Zone an die zweite n-dotierte Halbleiterschicht auf der der aktiven Zone abgewandten Seite des Tunnelkontakts anschließt. Diese weitere Halbleiterschicht grenzt ihrerseits an eine dritte n-dotierte Halbleiterschicht, wobei auch diese weitere Halbleiterschicht zunächst mittels materialselektiver Ätzung lateral bis zu einem gewünschten Durchmesser abgetragen und anschließend in einer geeigneten Atmosphäre so lange erhitzt wird, bis der geätzte Spalt durch Massetransport aus zumindest einer der an die weitere Halbleiterschicht grenzenden n-dotierten Halbleiterschichten geschlossen ist.

Hierbei ist es vorteilhaft, die laterale materialselektive Ätzung sowie den Massetransport-Prozess zeitgleich mit der entsprechenden erfindungsgemäßen Herstellung des vergrabenen Tunnelkontakts vorzunehmen.

Wird für die weitere Halbleiterschicht ein anderes Material, z. B. InGaAsP, als für den Tunnelkontakt, z. B. InGaAs, verwendet, kann eine unterschiedliche laterale Ätzung ausgenutzt werden, wodurch der laterale Wellenleiter - definiert durch den Durchmesser der weiteren Halbleiterschicht - breiter werden kann als der aktive Bereich, dessen Durchmesser dem Durchmesser des Tunnelkontakts entspricht. Diese Ausführungsform erlaubt damit eine kontrollierte und von der Stromapertur unabhängige Einstellung der lateralen Wellenführung. Hierzu wird diese weitere Halbleiterschicht nicht in einem Knoten, sondern z. B. in einem Bauch (Maximum) des longitudinalen elektrischen Feldes angeordnet.

Der Bandabstand der weiteren Halbleiterschicht sollte größer sein als derjenige der aktiven Zone, um optische Absorption zu vermeiden.

Zur materialselektiven Ätzung hat sich eine nasschemische Ätzung mit H₂SO₄:H₂O₂:H₂O Ätzlösung im Verhältnis von 3:1:1 bis 3:1:20 als vorteilhaft erwiesen, wenn der Tunnelkontakt aus InGaAs, InGaAsP oder InGaAlAs besteht.

Ein entsprechend dem erfindungsgemäßen Verfahren hergestellter vergrabener Tunnelkontakt in einem oberflächenemittierenden Halbleiterlaser weist mehrere Vorteile auf: Im Vergleich zu bisherigen Lösungen der Überwachsung des Tunnelkontakts mit einem zweiten Epitaxieprozess, ist nunmehr nur noch ein Epitaxieprozess notwendig, weshalb die Laserdioden preiswerter und mit höherer Ausbeute zu fertigen sind. Bei Verwendung von InP für den Massetransport-Prozess entstehen den Tunnelkontakt lateral einschließende Bereiche, die den Stromfluss seitlich vom Tunnelkontakt sperren und gleichzeitig wesentlich zur Wärmeleitung in die benachbarten Schichten beitragen. Zudem weist ein erfindungsgemäß hergestellter oberflächenemittierender Halbleiterlaser nur eine sehr geringe eingebaute Wellenführung auf, was die Stabilisierung des lateralen Einmodenbetriebs auch bei größeren Aperturen erleichtert und damit insgesamt höhere Einmodenleistungen als bei bisherigen Lösungen ergibt.

Ein oberflächenemittierender Halbleiterlaser gemäß Erfindung ist im Anspruch 11 angegeben, vorteilhafte Ausgestaltungen in den entsprechenden Unteransprüchen. Die jeweiligen Vorteile dieses oberflächenemittierenden Halbleiterlasers wurden im wesentlichen mit der Schilderung des erfindungsgemäßen Verfahrens angegeben. Weitere Vorteile und Ausgestaltungen der Erfindung ergeben sich aus den nachfolgenden Ausführungsbeispielen. Hierbei zeigt
- Figur 1: die schematische Darstellung eines vergrabenen Tunnelkontakts bei bekannten oberflächenemittierenden Halbleiterlasern,
- Figur 2: einen Querschnitt durch einen bekannten oberflächenemittierenden Halbleiterlaser mit vergrabenem Tunnelkontakt (BTJ-VCSEL) in schematischer Darstellung,
- Figur 3: eine typische epitaktische Ausgangsstruktur für einen erfindungsgemäßen Massetransport-VCSEL (MT-VCSEL) in schematischer Ansicht im Querschnitt,
- Figur 4: die Struktur von Figur 3 mit geformten Stempel,
- Figur 5: die Struktur von Figur 3 mit tiefer geformten Stempel,
- Figur 6: die Struktur gemäß Figur 4 nach Unterätzen der Tunnelkontaktschicht,
- Figur 7: die Struktur gemäß Figur 6 nach dem Massetransport-Prozess,
- Figur 8: eine schematische Querschnittsansicht eines erfindungsgemäßen MT-VCSEL,
- Figur 9: eine verbesserte Ausführungsform einer epitaktischen Ausgangsstruktur und
- Figur 10: eine schematische Querschnittsansicht einer weiteren Ausführungsform der Erfindung.

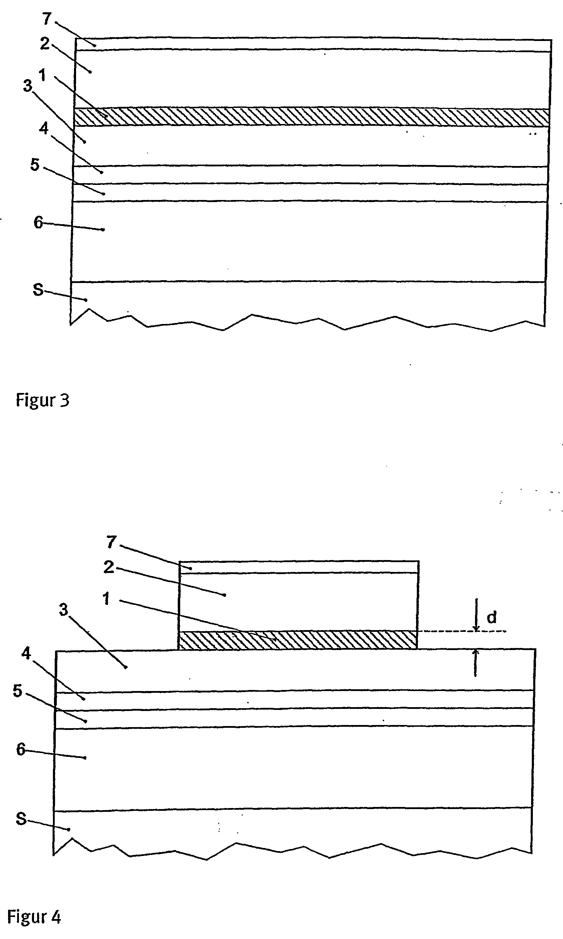

In der Beschreibungseinleitung wurden Herstellung und Struktur eines vergrabenen Tunnelkontakts und einer oberflächenemittierenden Laserdiode mit einem solchen Tunnelkontakt gemäß den Figuren 1 bzw. 2 beschrieben. Im Folgenden sollen Ausführungsformen der Erfindung anhand der Figuren 3 bis 10 näher erläutert werden.

Figur 3 zeigt schematisch eine typische epitaktische Ausgangsstruktur für einen erfindungsgemäßen MT-VCSEL. Ausgehend vom InP-Substrat S werden nacheinander ein n-dotierter epitaktischer Bragg-Spiegel 6, eine aktive Zone 5, eine optionale p-dotierte InAlAs-Schicht 4, eine p-dotierte untere InP-Schicht 3, ein aus mindestens jeweils einer hoch p- und n-dotierten Halbleiterschicht bestehender Tunnelkontakt 1, der sich in einem Knoten (Minimum) des longitudinalen elektrischen Feldes befindet, eine n-dotierte obere InP-Schicht 2 und eine n⁺-dotierte obere Kontaktschicht 7 abgeschieden.

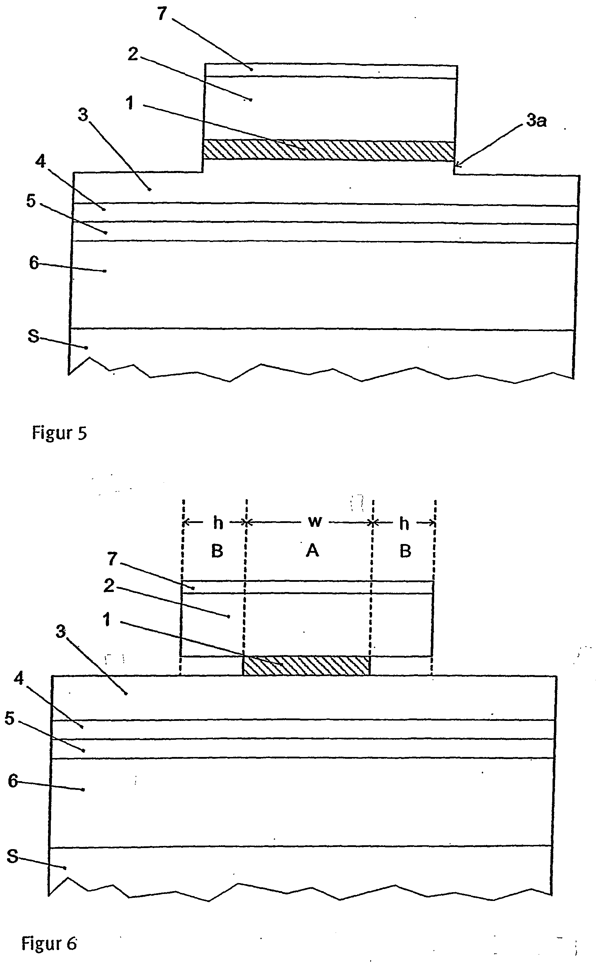

Anschließend werden durch Photolithographie und Ätzung kreisförmige oder elliptische Stempel auf einem Wafer mit der Ausgangsstruktur gemäß Figur 3 hergestellt. Die Stempel sind in den Figuren 4 und 5 im Querschnitt zu sehen. Sie reichen mindestens bis unterhalb des Tunnelkontakts 1, der die Dicke d besitzt (vg1. Figur 4), oder bis in die untere p-InP-Schicht 3 (Figur 5), wodurch in diese untere Schicht 3 eine Kante 3a geätzt wird. Der Stempeldurchmesser (w+2h) ist typischerweise ca. 5 bis 20 µm größer als der vorgesehene Aperturdurchmesser w von typischerweise 3 bis 20 µm, sodass h ca. 3 bis 10 µm beträgt. h stellt hierbei (vgl. Figur 6) die Breite des unterätzten Bereichs B der für den Tunnelkontakt 1 vorgesehenen Schicht dar.

Mittels materialselektiver Ätzung wird nun, wie im Bild 6 dargestellt, der Tunnelkontakt 1 seitlich abgetragen, ohne dass dabei die ihn umgebenden Schichten, hier die n-dotierte obere InP-Schicht 2 und die p-dotierte untere InP-Schicht 3, geätzt werden. Die seitliche Unterätzung des Tunnelkontakts 1 (bzw. der für den Tunnelkontakt vorgesehenen Schicht) von typischerweise h= 2 bis 10 µm dient zur Definition der Apertur A, die der verbleibenden Tunnelkontaktfläche entspricht. Die materialselektive Ätzung ist beispielsweise nasschemisch möglich mit H₂SO₄:H₂O₂:H₂O Ätzlösung in einem Verhältnis von 3:1:1 bis 3:1:20, wenn der Tunnelkontakt 1 aus InGaAs, InGaAsP oder InGaAlAs besteht.

Um nun einen vergrabenen Tunnelkontakt 1 in der in Figur 6 dargestellten Struktur zu erhalten, wird erfindungsgemäß der geätzte Spalt, also der den Tunnelkontakt 1 lateral umgebende Bereich B mittels eines Massetransport-Prozesses verschlossen. Hierzu wird der Wafer mit der in Figur 6 dargestellten Struktur unter phosphorhaltiger Atmosphäre für einige Zeit vorzugsweise auf 500 bis 600°C erhitzt. Typische Zeitdauern betragen 5 bis 30 Minuten. Während dieses Prozesses werden geringe Mengen InP von der oberen und/oder unteren InP-Schicht 2 bzw. 3 in den zuvor geätzten Spalt bewegt, der sich dadurch schließt.

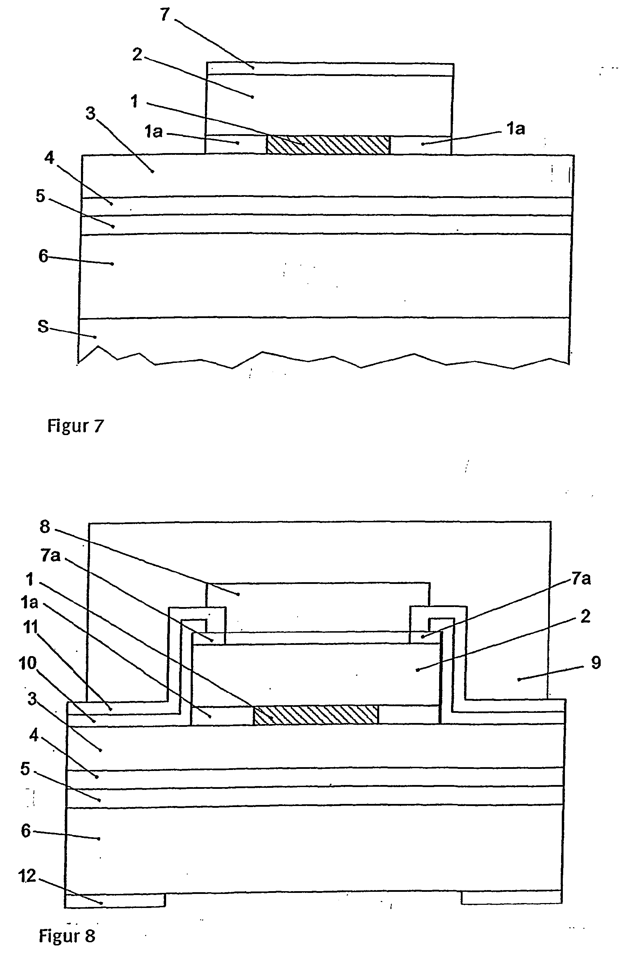

Das Ergebnis des Massetransport-Prozesses ist in Figur 7 gezeigt. Das transportierte InP im Bereich 1a schließt nun den Tunnelkontakt 1 lateral ein (vergräbt ihn). Aufgrund des hohen Bandabstands von InP und der geringen Dotierung stellen die Bereiche la keine Tunnelkontakte dar und sperren daher den Stromfluss. Damit entspricht der stromdurchflossene Bereich der aktiven Zone 5 mit dem Durchmesser w (vgl. Figur 6) weitgehend der Fläche (Apertur A in Figur 6) des Tunnelkontakts 1. Andererseits tragen die aus InP bestehenden ringförmigen Bereiche la mit der Ringbreite h aufgrund der hohen Wärmeleitfähigkeit von InP wesentlich mit zur Wärmeabfuhr über die obere InP-Schicht 2 bei.

Die weitere Prozessierung der Struktur gemäß Figur 7 zum fertigen MT-VCSEL entspricht der von den BTJ-VCSELs her bekannten Technik, wie sie eingangs sowie in den zitierten Literaturstellen beschrieben ist, und soll daher hier nicht näher beschrieben werden. Figur 8 zeigt den fertigen erfindungsgemäßen MT-VCSEL. Hierbei ist eine integrierte Gold-Wärmesenke mit 9 bezeichnet, 8 bezeichnet einen dielektrischen Spiegel, der an die obere n-dotierten InP-Schicht 2 grenzt und von der Gold-Wärmesenke 9 umgeben wird, 7a bezeichnet die ringförmig strukturierte n-seitige Kontaktschicht, und mit 10 ist eine Isolations- und Passivierungsschicht, z. B. aus Si₃N₄ oder Al₂O₃, bezeichnet, die sowohl die p-dotierte untere als auch die n-dotierte obere InP-Schicht 3, 2 vor einem direkten Kontakt mit dem p-seitigen Kontakt 11 bzw. der Gold-Wärmesenke 9 schützt. Der p-seitige Kontakt 11 ist beispielsweise aus Ti/Pt/Au hergestellt. 12 bezeichnet den n-seitigen Kontakt aus z. B. Ti/Pt/Au.

Es sei in diesem Zusammenhang darauf hingewiesen, dass die aktive Zone 5, die hier als homogene Schicht gezeigt ist, meistens aus einer Schichtenstruktur von beispielsweise 11 dünnen Schichten (5 Quantenfilm- und 6 Barrierenschichten besteht).

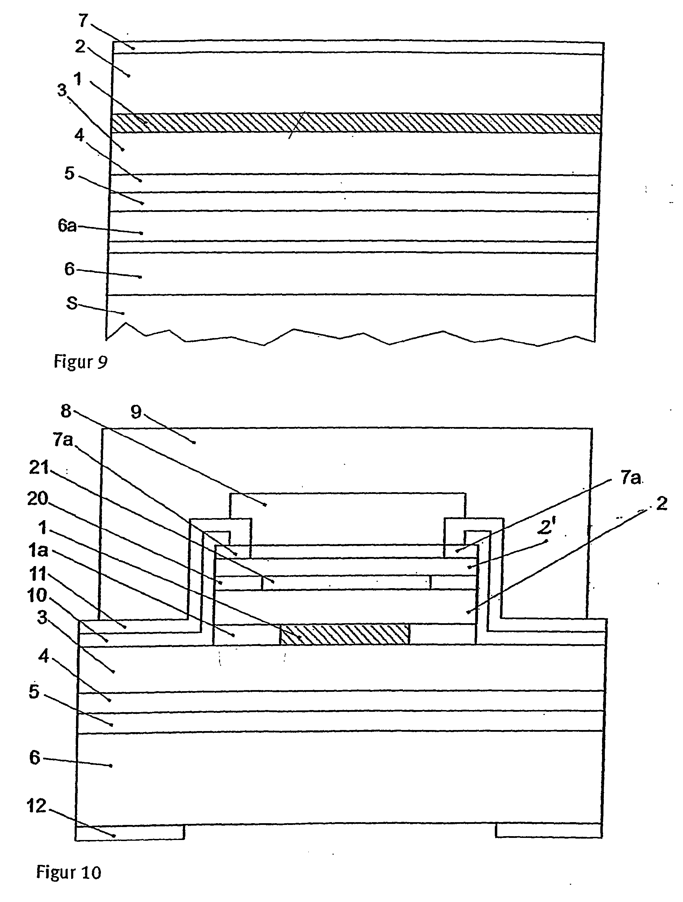

Eine verbesserte Ausführungsform der epitaktischen Ausgangsstruktur ist in Figur 9 dargestellt, bei der unterhalb der aktiven Zone 5 eine zusätzliche n-dotierte InP-Schicht 6a eingefügt ist. Diese Schicht verstärkt den lateralen Wärmeabfluss von der aktiven Zone 5 und reduziert damit deren Temperatur.

Eine weitere Ausführungsform der Erfindung ist in Figur 10 gezeigt. Hier wird die Massentransport-Technik in zwei übereinander liegenden Schichten angewendet, wobei vorzugsweise ein einziger Massentransport-Prozess sowohl für die Tunnelkontaktschicht als auch für die weitere Halbleiterschicht 21 ausgeführt wird. In Figur 10 ist diese weitere Halbleiterschicht 21 oberhalb des Tunnelkontakts 1 angeordnet. Die weitere Halbleiterschicht 21 grenzt an zwei n-dotierte InP-Schichten 2, 2'. Der die weitere Halbleiterschicht 21 lateral umgebende Bereich 20 besteht aus InP, das durch Massetransport in den vorher unterätzten Bereich 20 gelangt ist und diesen verschließt.

Sofern der Brechungsindex der weiteren Halbleiterschicht 21 sich von dem des umgebenden InP unterscheidet, erzeugt diese Schicht 21 eine kontrollierte laterale Wellenführung, indem diese Schicht nicht in einem Knoten, sondern z. B. in einem Bauch (Maximum) des longitudinalen elektrischen Feldes angeordnet wird. Bei Verwendung unterschiedlicher Halbleiter, z. B. InGaAs für den Tunnelkontakt 1 und InGaAsP für die weitere Halbleiterschicht 21, kann eine unterschiedliche laterale Ätzung ausgenutzt werden, wodurch der laterale Wellenleiter, der durch dem Durchmesser der Schicht 21 definiert wird, breiter wird als der aktive Bereich der aktiven Zone 5, dessen Durchmesser den Durchmesser des Tunnelkontakts 1 entspricht. Diese Ausführungsform erlaubt damit eine kontrollierte und von der Stromapertur unabhängige Einstellung der lateralen Wellenführung.

## Patentansprüche

1. Verfahren zur Herstellung eines vergrabenen Tunnelkontakts (1) in einem oberflächenemittierenden Halbleiterlaser mit einer einen pn-Übergang aufweisenden aktiven Zone (5) umgeben von einer ersten n-dotierten Halbleiterschicht (6) und mindestens einer p-dotierten Halbleiterschicht (3, 4), und mit einem Tunnelkontakt (1) auf der p-Seite der aktiven Zone (5), der an eine zweite n-dotierte Halbleiterschicht (2) grenzt, **dadurch gekennzeichnet, dass**
die für den Tunnelkontakt (1) vorgesehene Schicht in einem ersten Schritt mittels materialselektiver Ätzung bis zum gewünschten Durchmesser des Tunnelkontakts (1) lateral abgetragen wird und in einem zweiten Schritt in einer geeigneten Atmosphäre so lange erhitzt wird, bis der geätzte Spalt durch Massentransport aus zumindest einer an den Tunnelkontakt (1) grenzenden Halbleiterschicht (2, 3) geschlossen ist.

2. Verfahren nach Anspruch 1, **dadurch gekennzeichnet, dass** zumindest eine der an den Tunnelkontakt (1) grenzenden Halbleiterschichten (2, 3) aus einer Phosphid-Verbindung, vorzugsweise aus InP, besteht.

3. Verfahren nach Anspruch 1 oder 2, **dadurch gekennzeichnet, dass** als Atmosphäre in dem genannten zweiten Schritt eine Phosphor-Atmosphäre, vorzugsweise PH₃ und Wasserstoff, verwendet wird.

4. Verfahren nach einem der Ansprüche 1 bis 3, **dadurch gekennzeichnet, dass** die Temperatur im genannten zweiten Schritt zwischen 500 und 800°C, vorzugsweise zwischen 500 und 600°C, gewählt wird.

5. Verfahren nach einem der Ansprüche 1 bis 4, **dadurch gekennzeichnet, dass** ausgehend von einer epitaktischen Ausgangsstruktur des oberflächenemittierenden Halbleiterlasers, bei der auf der p-Seite der aktiven Zone (5) nacheinander eine p-dotierte Halbleiterschicht (3), die für den Tunnelkontakt (1) vorgesehene Schicht und die zweite n-dotierte Halbleiterschicht (2) aufgebracht sind, mittels Photolithographie und/oder Ätzung ein kreisförmiger oder elliptischer Stempel geformt wird, dessen Flanken die zweite n-dotierte Halbleiterschicht (2) und die für den Tunnelkontakt (1) vorgesehene Schicht umfassen und zumindest bis unterhalb der für den Tunnelkontakt (1) vorgesehenen Schicht reichen, und dass anschließend der genannte erste und der genannte zweite Schritt zur Herstellung des vergrabenen Tunnelkontakts (1) ausgeführt werden.

6. Verfahren nach einem der Ansprüche 1 bis 5, **dadurch gekennzeichnet, dass** sich auf der p-Seite der aktiven Zone (5) an die zweite n-dotierte Halbleiterschicht (2) eine weitere Halbleiterschicht (21) anschließt, die ihrerseits an eine dritte n-dotierte Halbleiterschicht (2') grenzt, wobei mittels materialselektiver Ätzung diese weitere Halbleiterschicht (21) bis zu einem gewünschten Durchmesser lateral abgetragen wird und anschließend in einer geeigneten Atmosphäre so lange erhitzt wird, bis der geätzte Spalt durch Massetransport aus zumindest einer an die weitere Halbleiterschicht (21) grenzenden Halbleiterschichten (2, 2') geschlossen ist.

7. Verfahren nach Anspruch 6, **dadurch gekennzeichnet, dass** für die weitere Halbleiterschicht (21) und für den Tunnelkontakt (1) unterschiedliche Halbleiter verwendet werden.

8. Verfahren nach Anspruch 7, **dadurch gekennzeichnet, dass** für die weitere Halbleiterschicht (21) InGaAsP und für den Tunnelkontakt (1) InGaAs verwendet werden.

9. Verfahren nach einem der Ansprüche 6 bis 8, **dadurch gekennzeichnet, dass** die weitere Halbleiterschicht (21) in einem Maximum des longitudinalen elektrischen Feldes angeordnet wird, während sich der Tunnelkontakt (1) in ein Minimum des longitudinalen elektrischen Feldes befindet.

10. Verfahren nach einem der Ansprüche 1 bis 9, **dadurch gekennzeichnet, dass** zur materialselektiven Ätzung als Ätzlösung H₂SO₄:H₂O₂:H₂O in einem Verhältnis von 3:1:1 bis 3:1:20 verwendet wird, wenn der Tunnelkontakt (1) aus InGaAs, InGaAsP oder InGaAlAs besteht.

11. Oberflächenemittierender Halbleiterlaser, der eine einen pn-Übergang aufweisende aktive Zone (5) umgeben von einer ersten n-dotierten Halbleiterschicht (6) und mindestens einer p-dotierten Halbleiterschicht (3, 4) aufweist, sowie einen Tunnelkontakt (1) auf der p-Seite der aktiven Zone (5), der an eine zweite n-dotierte Halbleiterschicht (2) grenzt, **dadurch gekennzeichnet, dass**
der Tunnelkontakt (1) lateral von einem Bereich (1a) umgeben ist, der die zweite n-dotierte Halbleiterschicht (2) mit einer der p-dotierten Halbleiterschichten (3, 4) verbindet und durch Massetransport aus zumindest einer dieser angrenzenden Schichten (2, 3) entstanden ist, indem die für den Tunnenkontakt (1) vorgesehene Schicht in einem ersten Schritt mittels materialselektiver Ätzung bis zum gewünschten Durchmesser des Tunnelkontakts (1) lateral abgetragen wird und in einem zweiten Schritt in einer geeigneten Athmosphäre solange erhitzt wird, bis der geätzte Spalt durch Massentransport aus zumindest einer an den Tunnelkontakt (1) grenzenden Halbleiterschicht (2, 3) geschlossen ist.

12. Oberflächenemittierender Halbleiterlaser nach Anspruch 11, **dadurch gekennzeichnet, dass** zumindest eine der an den Tunnelkontakt (1) grenzenden Halbleiterschichten (2, 3) aus einer Phosphid-Verbindung, vorzugsweise aus InP, besteht.

13. Oberflächenemittierender Halbleiterlaser nach Anspruch 11 oder 12, **dadurch gekennzeichnet, dass** sich an die aktive Zone (5) als die mindestens eine p-dotierte Halbleiterschicht eine p-dotierte InAlAs-Schicht (4) gefolgt von einer p-dotierten InP-Schicht (3) anschließt.

14. Oberflächenemittierender Halbleiterlaser nach einem der Ansprüche 11 bis 13, **dadurch gekennzeichnet, dass** der Tunnelkontakt (1) in einem Minimum des longitudinalen elektrischen Feldes angeordnet ist.

15. Oberflächenemittierender Halbleiterlaser nach einem der Ansprüche 11 bis 14, **dadurch gekennzeichnet, dass** eine weitere n-dotierte Halbleiterschicht (6a) zwischen der aktiven Zone (5) und der ersten Halbleiterschicht (6), die als Halbleiterspiegel ausgebildet ist, vorhanden ist.

16. Oberflächenemittierender Halbleiterlaser nach einem der Ansprüche 11 bis 15, **dadurch gekennzeichnet, dass** eine weitere Halbleiterschicht (21) vorgesehen ist, die sich an die an den Tunnelkontakt (1) grenzende zweite n-dotierte Halbleiterschicht (2) anschließt, und die ihrerseits an eine dritte n-dotierte Halbleiterschicht (2') grenzt, wobei diese weitere Halbleiterschicht (21) lateral von einem Bereich (20) umgeben ist, der die zweite n-dotierte Halbleiterschicht (2) mit der dritten n-dotierten Halbleiterschicht (2') verbindet und durch Massetransport aus zumindest einer dieser beiden Schichten (2, 2') entstanden ist, wobei mittels materialselektiver Ätzung diese weitere Halbleiterschicht (21) bis zu einem gewünschten Durchmesser lateral abgetragen wird und anschließend in einer geeigneten Athmosphäre solange erhitzt wird, bis der geätzte Spalt durch Massetransport aus zumindest einer an die weitere Halbleiterschicht (21) grenzenden Halbleiterschichten (2, 2') geschlossen ist.

17. Oberflächenemittierender Halbleiterlaser nach Anspruch 16, **dadurch gekennzeichnet, dass** sich der Brechungsindex der weiteren Halbleiterschicht (21) von dem bzw. denen der beiden umgebenden Schichten (2, 2') unterscheidet.

18. Oberflächenemittierender Halbleiterlaser nach Anspruch 16 oder 17, **dadurch gekennzeichnet, dass** die weitere Halbleiterschicht (21) in einem Maximum des longitudinalen elektrischen Feldes angeordnet ist.

19. Oberflächenemittierender Halbleiterlaser nach einem der Ansprüche 16 bis 18, **dadurch gekennzeichnet, dass** die weitere Halbleiterschicht (21) und der Tunnelkontakt (1) aus unterschiedlichen Halbleitermaterialien bestehen.

20. Oberflächenemittierender Halbleiterlaser nach Anspruch 19, **dadurch gekennzeichnet, dass** die weitere Halbleiterschicht (21) aus InGaAsP und der Tunnelkontakt (1) aus InGaAs besteht.

21. Oberflächenemittierender Halbleiterlaser nach einem der Ansprüche 16 bis 20, **dadurch gekennzeichnet, dass** der Durchmesser der weiteren Halbleiterschicht (21) größer ist als der des Tunnelkontakts (1).

22. Oberflächenemittierender Halbleiterlaser nach einem der Ansprüche 16 bis 21, **dadurch gekennzeichnet, dass** der Bandabstand der weiteren Halbleiterschicht (21) größer ist als der Bandabstand der aktiven Zone (5).

## Claims

1. A method for producing a buried tunnel junction (1) in a surface-emitting semi-conductor laser having an active zone (5) with a pn-junction surrounded by a first n-doped semi-conductor layer (6) and at least one p-doped semi-conductor layer (3, 4) and having a tunnel junction (1) on the p-side of the active zone (5), which borders on a second n-doped semi-conductor layer (2),
**characterized in that**
the layer destined for the tunnel junction (1) is laterally ablated in a first step by means of material-selective etching up to a desired diameter of the tunnel junction (1) and in a second step is heated in a suitable atmosphere, until the etched gap is closed by mass transport from at least one semi-conductor layer (2, 3) bordering on the tunnel junction (1).

2. The method according to Claim 1, wherein at least one of the semi-conductor layers (2, 3) bordering on the tunnel junction (1) consists of a phosphide compound, preferably consisting of InP.

3. The method according to Claim 1 or 2, wherein as atmosphere in the said second step a phosphoric atmosphere, preferably PH₃ and hydrogen, is used.

4. The method according to one of Claims 1 to 3, wherein the temperature in the said second step is chosen to be between 500 and 800 °C , preferably between 500 and 600 °C.

5. The method according to one of Claims 1 to 4, wherein, starting with an epitaxial initial structure of the surface-emitting semi-conductor laser, in which a p-doped semi-conductor layer (3), the layer destined for the tunnel junction (1), and the second n-doped semi-conductor layer (2) are applied sequentially on the p-side of the active zone (5), using photolithography and / or etching a circular or ellipsoid stamp is formed, whose flanks encompass the second n-doped semi-conductor layer (2) and the layer destined for the tunnel junction (1) and extend at least to underneath the layer destined for the tunnel junction (1), and, subsequently, said first and said second steps are embodied for producing the buried tunnel junction (1).

6. The method according to one of Claims 1 to 5, wherein an additional semi-conductor layer (21) adjoins the second n-doped semi-conductor layer (2) at the p-side of the active zone (5), said additional semi-conductor layer (21) in turn borders on a third n-doped semi-conductor layer (2'), whereby this additional semi-conductor layer (21) is laterally ablated up to a desired diameter by means of material-selective etching and then is heated in a suitable atmosphere until the etched gap is closed by mass transport from at least one of the semi-conductor layers (2, 2') bordering on the additional semi-conductor layer (21).

7. The method according to Claim 6, wherein different semi-conductors are used for the additional semi-conductor layer (21) and for the tunnel junction (1).

8. The method according to Claim 7, wherein InGaAsP is used for the additional semi-conductor layer (21) and InGaAs is used for the tunnel junction (1).

9. The method according to one of Claims 6 to 8, wherein the additional semi-conductor layer (21) is arranged in a maximum of the longitudinal electrical field, while the tunnel junction (1) is in a minimum of the longitudinal electrical field.

10. The method according to one of Claims 1 to 9, wherein for the material-selective etching H₂SO_{4:}H₂0₂:H₂O is used as the etching solution in a ratio of 3:1:1 to 3:1:20, if the tunnel junction (1) is comprised of InGaAs, InGaAsP or InGaAlAs.

11. A surface-emitting semi-conductor laser having an active zone (5) with a pn-junction surrounded by a first n-doped semi-conductor layer (6) and at least one p-doped semi-conductor layer (3, 4), and a tunnel junction (1) on the p-side of the active zone (5), which borders on a second n-doped semi-conductor layer (2),
**characterized in that**
the tunnel junction (1) is laterally embraced by a zone (1a), which connects the second n-doped semi-conductor layer (2) with one of the p-doped semi-conductor layers (3, 4) and which is formed from at least one of these adjacent layers (2, 3) by mass transport, the layer destined for the tunnel junction (1) being laterally ablated in a first step by means of material-selective etching up to a desired diameter of the tunnel junction (1) and in a second step being heated in a suitable atmosphere, until the etched gap is closed by mass transport from at least one semi-conductor layer (2, 3) bordering on the tunnel junction (1).

12. A surface-emitting semi-conductor laser according to Claim 11, wherein at least one of the semi-conductor layers (2, 3) bordering on the tunnel junction (1) consists of a phosphide compound, preferably consisting of InP.

13. A surface-emitting semi-conductor laser according to Claim 11 or 12, **characterized in that** a p-doped InAlAs layer (4) followed by a p-doped InP layer (3) abuts as the at least one p-doped semi-conductor layer with the active zone (5).

14. The surface-emitting semi-conductor laser according to one of Claims 11 to 13, wherein the tunnel junction (1) is arranged in a minimum of the longitudinal electrical field.

15. The surface-emitting semi-conductor laser according to one of Claims 11 to 14, wherein an additional n-doped semi-conductor layer (6a) is present between the active zone (5) and the first semi-conductor layer (6), which is configured as a semi-conductor mirror.

16. The surface-emitting semi-conductor laser according to one of Claims 11 to 15, wherein an additional semi-conductor layer (21) is present, which abuts on the second n-doped semi-conductor layer (2) bordering on the tunnel junction (1) and which itself borders on a third n-doped semiconductor layer (2'), whereby this additional semi-conductor layer (21) is laterally surrounded by a zone (20), that connects the second n-doped semi-conductor layer (2) with the third n-doped semi-conductor layer (2') and is generated by mass transport from at least one of these two layers (2, 2'), whereby this additional semi-conductor layer (21) is laterally ablated up to a desired diameter by means of material-selective etching and then is heated in a suitable atmosphere until the etched gap is closed by mass transport from at least one of the semi-conductor layers (2, 2') bordering on the additional semi-conductor layer (21) .

17. The surface-emitting semi-conductor laser according to Claim 16, wherein the refractive index of the additional semi-conductor layer (21) differs from the one or those of the two surrounding layers (2, 2').

18. A surface emitting semi-conductor laser according to Claim 16 or 17, wherein the additional semi-conductor layer (21) is arranged in a maximum of the longitudinal electrical field.

19. The surface emitting semi-conductor laser according to one of Claims 16 to 18, wherein the additional semi-conductor layer (21) and the tunnel junction (1) are comprised of different semi-conductor materials.

20. The surface-emitting semi-conductor laser according to Claim 19, wherein the additional semi-conductor layer (21) is comprised of InGaAsP and the tunnel junction (1) of InGaAs.

21. The surface-emitting semi-conductor laser according to one of Claims 16 to 20, wherein the diameter of the additional semi-conductor layer (21) is greater than that of the tunnel junction (1).

22. The surface-emitting semi-conductor laser according to one of Claims 16 to 21, wherein the band gap of the additional semi-conductor layer (21) is greater than the band gap of the active zone (5).

## Revendications

1. Procédé pour produire une jonction à effet tunnel enfouie (1) dans un laser à semi-conducteurs émettant par la surface ayant une zone active (5) munie d'une jonction pn entourée d'une première couche à semi-conducteurs dopée à n (6) et d'au moins une couche à semi-conducteurs dopée à p (3, 4) et ayant une jonction à effet tunnel (1) sur le côté p de la zone active (5), qui borde une deuxième couche à semi-conducteurs dopée à n (2),
**caractérisé en ce que**
la couche destinée pour la jonction à effet tunnel (1) est latéralement soumise à une ablation dans une première étape par l'intermédiaire d'une attaque chimique à sélection de matériau jusqu'à un diamètre voulu de la jonction à effet tunnel (1) et dans une seconde étape est chauffée dans une condition atmosphérique adaptée, jusqu'à ce que l'intervalle attaqué soit fermé par un transfert de masse à partir d'au moins une couche à semi-conducteurs (2, 3) bordant la jonction à effet tunnel (1).

2. Procédé selon la revendication 1, dans lequel au moins l'une des couches à semi-conducteurs (2, 3) bordant la jonction à effet tunnel (1) est constituée d'un composé de phosphure, de préférence constitué de InP.

3. Procédé selon la revendication 1 ou 2, dans lequel en tant que condition atmosphérique dans ladite seconde étape, une condition atmosphère phosphorique, de préférence de PH₃ et de l'hydrogène, est utilisée.

4. Procédé selon l'une quelconque des revendications 1 à 3, dans lequel la température dans ladite seconde étape est sélectionnée de manière à être entre 500 et 800°C, de préférence entre 500 et 600°C.

5. Procédé selon l'une quelconque des revendications 1 à 4, dans lequel, en commençant par une structure initiale épitaxiale du laser à semi-conducteurs émettant par la surface, dans lequel une couche à semi-conducteurs dopée à p (3), la couche destinée pour la jonction à effet tunnel (1), et la deuxième couche à semi-conducteurs dopée à n (2) sont appliquées séquentiellement sur le côté p de la zone active (5), en utilisant la photolithographie et/ou attaque chimique, un timbre circulaire ou ellipsoïdal est formé, dont les flancs enveloppent la deuxième couche à semi-conducteurs dopée à n (2) et la couche destinée pour la jonction à effet tunnel (1) et s'étendent au moins jusqu'au-dessous de la couche destinée pour la jonction à effet tunnel (1), et, par la suite, lesdites première et seconde étapes sont mises en oeuvre pour produire la jonction à effet tunnel enfouie (1).

6. Procédé selon l'une quelconque des revendications 1 à 5, dans lequel une couche à semi-conducteurs supplémentaire (21) avoisine la deuxième couche à semi-conducteurs dopée à n (2) au niveau du côté p de la zone active (5), ladite couche à semi-conducteurs supplémentaire (21) borde à son tour une troisième couche à semi-conducteurs dopée à n (2'), de sorte que cette couche à semi-conducteurs supplémentaire (21) subit latéralement une ablation jusqu'à un diamètre voulu par l'intermédiaire d'une attaque chimique à sélection de matériau et ensuite est chauffée dans une condition atmosphérique adaptée jusqu'à ce que l'intervalle attaqué soit fermé par un transfert de masse à partir d'au moins l'une des couches à semi-conducteurs (2, 2') bordant la couche à semi-conducteurs supplémentaire (21).

7. Procédé selon la revendication 6, dans lequel des semi-conducteurs différents sont utilisés pour la couche à semi-conducteurs supplémentaire (21) et pour la jonction à effet tunnel (1).

8. Procédé selon la revendication 7, dans lequel InGaAsP est utilisé pour la couche à semi-conducteurs supplémentaire (21) et InGaAs est utilisé pour la jonction à effet tunnel (1).

9. Procédé selon l'une quelconque des revendications 6 à 8, dans lequel la couche à semi-conducteurs supplémentaire (21) est agencée dans un maximum du champ électrique longitudinal, tandis que la jonction à effet tunnel (1) l'est dans un minimum du champ électrique longitudinal.

10. Procédé selon l'une quelconque des revendications 1 à 9, dans lequel pour l'attaque chimique à sélection de matériau, H₂SO₄:H₂O₂:H₂O est utilisé en tant que solution d'attaque selon un rapport de 3:1:1 à 3:1:20, si la jonction à effet tunnel (1) est constituée de InGaAs, InGaAsP ou InGaAlAs.

11. Laser à semi-conducteurs émettant par la surface ayant une zone active (5) munie d'une jonction pn entourée d'une première couche à semi-conducteurs dopée à n (6) et d'au moins une couche à semi-conducteurs dopée à p (3, 4), et une jonction à effet tunnel (1) sur le côté p de la zone active (5), qui borde une deuxième couche à semi-conducteurs dopée à n (2),
**caractérisé en ce que**
la jonction à effet tunnel (1) est latéralement renfermée par une zone (1a), qui relie la deuxième couche à semi-conducteurs dopée à n (2) à l'une des couches à semi-conducteurs dopées à p (3, 4) et qui est formée d'au moins l'une de ces couches adjacentes (2, 3) par un transfert de masse, la couche destinée pour la jonction à effet tunnel (1) étant latéralement soumise à une ablation dans une première étape par l'intermédiaire d'une attaque chimique à sélection de matériau jusqu'à un diamètre voulu de la jonction à effet tunnel (1) et dans une seconde étape étant chauffée dans une condition atmosphérique adaptée, jusqu'à ce que l'intervalle attaqué soit fermé par un transfert de masse à partir d'au moins une couche à semi-conducteurs (2, 3) bordant la jonction à effet tunnel (1).

12. Laser à semi-conducteurs émettant par la surface selon la revendication 11, dans lequel au moins l'une des couches à semi-conducteurs (2, 3) bordant la jonction à effet tunnel (1) est constituée d'un composé de phosphure, de préférence constitué de InP.

13. Laser à semi-conducteurs émettant par la surface selon la revendication 11 ou 12, **caractérisé en ce qu'**une couche de InAlAs dopée à p (4) en couche à semi-conducteurs dopée à p suivie d'une couche de InP dopée à p (3) bute contre la en la zone active (5).

14. Laser à semi-conducteurs émettant par la surface selon l'une quelconque des revendications 11 à 13, dans lequel la jonction à effet tunnel (1) est agencée dans un minimum du champ électrique longitudinal.

15. Laser à semi-conducteurs émettant par la surface selon l'une quelconque des revendications 11 à 14, dans lequel une couche à semi-conducteurs dopée à p supplémentaire (6a) est présente entre la zone active (5) et la première couche à semi-conducteurs (6), qui est configurée sous la forme d'un miroir à semi-conducteurs.

16. Laser à semi-conducteurs émettant par la surface selon l'une quelconque des revendications 1 à 15, dans lequel une couche à semi-conducteurs supplémentaire (21) est présente, qui bute contre la deuxième couche à semi-conducteurs dopée à n (2) bordant la jonction à effet tunnel (1) et qui elle-même borde une troisième couche à semi-conducteurs dopée à n (2'), de sorte que cette couche à semi-conducteurs supplémentaire (21) est latéralement entourée d'une zone (20), qui relie la deuxième couche à semi-conducteurs dopée à n (2) à la troisième couche à semi-conducteurs dopée à n (2') et est générée par un transfert de masse à partir d'au moins l'une de ces deux couches (2, 2'), de sorte que cette couche à semi-conducteurs supplémentaire (21) est latéralement soumise à une ablation jusqu'à un diamètre voulu par l'intermédiaire d'une attaque chimique à sélection de matériau et ensuite est chauffée dans une condition atmosphérique adaptée jusqu'à ce l'intervalle attaqué soit fermé par un transfert de masse à partir d'au moins l'une des couches à semi-conducteurs (2, 2') bordant la couche à semi-conducteurs supplémentaire (21).

17. Laser à semi-conducteurs émettant par la surface selon la revendication 16, dans lequel l'indice de réfraction de la couche à semi-conducteurs supplémentaire (21) diffère de celui ou de ceux des deux couches voisines (2, 2').

18. Laser à semi-conducteurs émettant par la surface selon la revendication 16 ou 17, dans lequel la couche à semi-conducteurs supplémentaire (21) est agencée dans un maximum du champ électrique longitudinal.

19. Laser à semi-conducteurs émettant par la surface selon l'une quelconque des revendications 16 à 18, dans lequel la couche à semi-conducteurs supplémentaire (21) et la jonction à effet tunnel (1) sont constituées de matériaux semi-conducteurs différents.

20. Laser à semi-conducteurs émettant par la surface selon la revendication 19, dans lequel la couche à semi-conducteurs supplémentaire (21) est constituée de InGaAsP et la jonction à effet tunnel (1) est constituée de InGaAs.

21. Laser à semi-conducteurs émettant par la surface selon l'une quelconque des revendications 16 à 20, dans lequel le diamètre de la couche à semi-conducteurs supplémentaire (21) est supérieur à celui de la jonction à effet tunnel (1).

22. Laser à semi-conducteurs émettant par la surface selon l'une quelconque des revendications 16 à 21, dans lequel la largeur de bande interdite de la couche à semi-conducteurs supplémentaire (21) est supérieure à la largeur de bande interdite de la zone active (5).
